# EUROPÄISCHE PATENTSCHRIFT

(11) **EP 1 232 486 B1**
(45) Veröffentlichungstag und Bekanntmachung des Hinweises auf die Patenterteilung: **18.06.2003**
(21) Anmeldenummer: 00993193.2
(22) Anmeldetag: 23.11.2000
(51) Int. Cl.: G07D 7/00, G07D 7/02

(54) **FLÄCHIGER TRÄGER MIT MINDESTENS EINEM HALBLEITERCHIP**
FLAT SUPPORT WITH AT LEAST ONE SEMICONDUCTOR CHIP
SUPPORT PLAT COMPORTANT AU MOINS UNE PUCE A SEMI-CONDUCTEUR

(30) Priorität: 25.11.1999 EP 99123207
(43) Veröffentlichungstag der Anmeldung: 21.08.2002
(73) Patentinhaber: Infineon Technologies AG, 81669 München (DE)
(72) Erfinder: REINER, Robert, 85579 Neubiberg (DE)
(74) Vertreter: Epping Hermann & Fischer
(86) Internationale Anmeldenummer: DE0004139
(87) Internationale Veröffentlichungsnummer: WO01039137

(56) Entgegenhaltungen:
- EP-A- 0 019 191
- EP-A- 0 905 657
- DE-A- 19 601 358

## Beschreibung

Die Erfindung betrifft einen flächigen Träger mit mindestens einem Halbleiterchip, der mit einer Antenne zum Austausch von Daten und Energie mit einem elektronischen Gerät verbunden ist, wobei die Antenne aus zwei elektrischen Leitern besteht.

Derartige Träger werden als passive Transponder bezeichnet. Die Antenne, die als elektrischer Dipol ausgeführt ist, tauscht die Daten und die Energie mit dem elektronischen Gerät über kapazitive Kopplung aus. Die von einer kapazitiven Antenne übertragbare Leistung ist durch deren Koppelkapazität begrenzt. Die Koppelkapazität ist einerseits durch den Abstand der kapazitiven Antenne des Transponders von der Antenne des elektronischen Gerätes und andererseits durch die Fläche der kapazitiven Antenne (des Transponders) bestimmt. Um eine hohe Koppelkapazität zu erzielen, muß der Abstand zwischen dem Transponder und dem elektronischen Gerät möglichst gering gehalten werden. Alternativ oder additiv nimmt die Koppelkapazität noch zu, je größer die Fläche der elektrischen Antenne ist.

Die Fläche der kapazitiven Antenne bestimmt sich durch die Länge und der Breite der verwendeten Leiter. Sie ist somit einerseits durch die Abmessungen des Trägers und andererseits durch das Herstellverfahren begrenzt. Wird als Träger ein Papier verwendet, so wird die Antenne während des Papierschopfens in das Papier eingebracht. Die Breite der Antenne ist bei einem derartigen Herstellungsverfahren relativ schmal, wodurch auch die Fläche der kapazitiven Antenne entsprechend gering ist.

Eine derartige Anordnung, bei der als Träger ein Papier verwendet wird und bei der die elektrische Antenne bzw. der elektrische Dipol parallel zu der kürzeren Kante des Papiers ausgeführt ist, ist aus der EP 0 905 657 A1 bekannt. Das Papier ist in diesem konkreten Ausführungsbeispiel eine Geldnote, wobei der Halbleiterchip in Verbindung mit dem elektrischen Dipol ein Sicherheitselement der Banknote darstellt. Ein derartiger, z.B. aus Papier bestehender Träger könnte auch für die Sicherung von Gegenständen in einem Kaufhaus verwendet werden. Gleichfalls ist es bekannt, einen derartigen Träger als Lage in einer Chipkartenanordnung zu verwenden.

Eine Verbreiterung der elektrischen Antenne zur Vergrößerung der Antennenfläche und somit der Koppelkapazität würde eine Abänderung des Herstellverfahrens nach sich ziehen. Ein derartiger Schritt ist mit außerordentlich hohen Kosten verbunden.

Die Aufgabe der vorliegenden Erfindung besteht nunmehr darin, einen gattungsgemäßen Transponder vorzusehen, bei dem die Kopplung zwischen der kapazitiven Antenne des Transponders und dem elektronischen Gerät verbessert werden kann.

Erfindungsgemäß wird diese Aufgabe dadurch gelöst, daß eine leitfähige Schicht auf dem Träger vorgesehen ist, die mit den elektrischen Leitern der Antenne überlappt. Die Koppelkapazität wird folglich dadurch vergrößert, daß die gegenüber dem elektronischen Gerät wirksame Fläche der Antenne vergrößert wird, indem eine breite leitfähige Schicht auf die Oberfläche des Papiers gebracht wird. Weitere vorteilhafte Ausgestaltungen ergeben sich aus den Unteransprüchen.

Vorteilhafterweise überlappt jeder der zwei elektrischen Leiter mit einer zugeordneten leitfähigen Schicht. Die jeweilige leitfähige Schicht überdeckt in einer besonders vorteilhaften Ausgestaltung dabei die jeweiligen elektrischen Leiter vollständig. Um eine möglichst hohe Kopplung zwischen dem Transponder und dem elektronischen Gerät zu erzielen, ist die Fläche der jeweiligen leitfähigen Schicht vorteilhafter Weise größer als die des jeweiligen elektrischen Leiters.

Bei einer Anordnung gemäß dem Stand der Technik wird die zur Kopplung notwendige Kapazität zwischen den elektrischen Leitern der Antenne des Transponders und der Antenne des elektronischen Gerätes gebildet. Die Koppelkapazität bestimmt sich, wie einleitend beschrieben, aus der Fläche und dem Abstand der beiden Antennen.

Durch das Vorsehen einer leitfähigen Schicht auf dem Träger, die mit den elektrischen Leitern der Antenne des Transponders überlappt, wird die Koppelkapazität durch ein "Parallelschalten" zweier seriell miteinander verschaltener Kapazitäten vergrößert. Die erste Kapazität wird zwischen den elektrischen Leitern und der leitfähigen Schicht gebildet. Die Koppelkapazität ist hierbei verhältnismäßig groß, da der Abstand zwischen der leitfähigen Schicht und den elektrischen Leitern der Antenne sehr klein ist. Der Abstand beträgt maximal die Dicke des Trägers, z.B. eines Papiers. Die zweite Kapazität wird durch die leitfähige Schicht und die Antenne des elektronischen Gerätes gebildet. Da die leitfähige Schicht eine große Fläche aufweist, ist zu dem elektronischen Gerät eine große Kopplung gegeben. Die Kopplung zwischen den elektrischen Leitern der Antenne und die Antenne des elektronischen Gerätes wird zwar verringert, da die leitfähige Schicht eine Abschirmung gleich kommt. Diese Verringerung ist jedoch unproblematisch, da die Koppelkapazität durch die Parallelschaltung der Serienschaltung der ersten und der zweiten Kapazität wesentlich vergrößert wird.

Vorteilhafterweise steht die leitfähige Schicht in direktem elektrischen Kontakt mit den elektrischen Leitern. Dies bedeutet nicht anderes, als daß die erste Kapazität der Parallelschaltung ihren maximal Wert annimmt. Eine derartige Anordnung kann dadurch erzielt werden, daß die leitfähige Schicht direkt auf die Seite des Trägers aufgebracht wird, auf der die elektrischen Leiter der Antenne des Transponders vorgesehen sind.

In einer Ausgestaltung der Erfindung kommt die leitfähige Schicht durch ein Dielektrikum beabstandet zu den elektrischen Leitern zum liegen. Das Dielektrikum kann dann beispielsweise der Träger selbst sein. Dies bedeutet nichts anderes, als daß die leitfähige Schicht und die elektrischen Leiter der Antenne auf den gegenüberliegenden großflächigen Seiten des Trägers vorgesehen sind.

In einer weiteren vorteilhaften Ausgestaltung sind die elektrischen Leiter der Antenne zusammen mit dem Halbleiterchip in dem Träger eingebettet. Hierdurch ist ein Schutz der elektrischen Leiter und des Halbleiterchips vor einer mechanischen Beschädigung gewährleistet.

In einer vorteilhaften Ausgestaltung der Erfindung ist die leitfähige Schicht bezüglich der elektrischen Leiter spiegelsymmetrisch angeordnet. Die leitfähige Schicht wird vorteilhafterweise auf dem Träger gedruckt und kann deshalb relativ hochohmig sein. Somit bestehen Zuleitungswiderstände zwischen der ersten und der zweiten Kapazität. Durch eine symmetrische Anordnung der leitfähige Schicht gegenüber den elektrischen Leitern können die Zuleitungswiderstände jedoch klein gehalten werden.

In einer weiteren vorteilhaften Ausgestaltung sind die elektrischen Leiter symmetrisch bezüglich des Halbleiterchips angeordnet. Dies bedeutet nichts anderes, als daß der elektrische Dipol zwei identisch ausgebildete elektrische Leiter aufweist.

In einer bevorzugten Ausgestaltung der Erfindung ist der Halbleiterchip außerhalb der Spiegelachsen des flächigen Trägers gelegen. Ist der flächige Träger nämlich flexibel und biegbar, so wird dieser häufig gefaltet. Die Praxis zeigt, daß eine Faltung in der Regel in der Mittelachse des Trägers vorgenommen wird. Ist der Halbleiterchip nun in einer dieser Mittelachsen des flächigen Trägers gelegen, so kann dieser durch das Falten beschädigt werden. Die Anordnung des Halbleiterchips außerhalb der Spiegelachsen bzw. Mittelachsen des Trägers verhindert eine Beschädigung und somit eine Funktionsstörung der gesamten Anordnung.

Weitere Vorteile und Ausführungen der Erfindung werden anhand der nachfolgenden Figuren näher erläutert. Es zeigen:
- Figur 1: einen aus dem Stand der Technik bekannten flächigen Träger in einer Draufsicht,
- Figuren 2a bis 2c: unterschiedliche Ausführungsformen des aus Figur 1 bekannten flächigen Trägers jeweils in einem Querschnitt,
- Figur 3: ein erstes Ausführungsbeispiel eines erfindungsgemäßen flächigen Trägers in einer Draufsicht,
- Figur 4a bis 4d: unterschiedliche Ausführungsformen des in Figur 3 gezeigten flächigen Trägers jeweils in einem Querschnitt,
- Figur 5: ein zweites Ausführungsbeispiel des erfindungsgemäßen flächigen Trägers,
- Figur 6: ein drittes Ausführungsbeispiel des erfindungsgemäßen flächigen Trägers in einer Draufsicht und
- Figur 7: das elektrische Ersatzschaltbild für die kapazitive Kopplung zwischen einem Transponder und einem elektronischen Gerät.

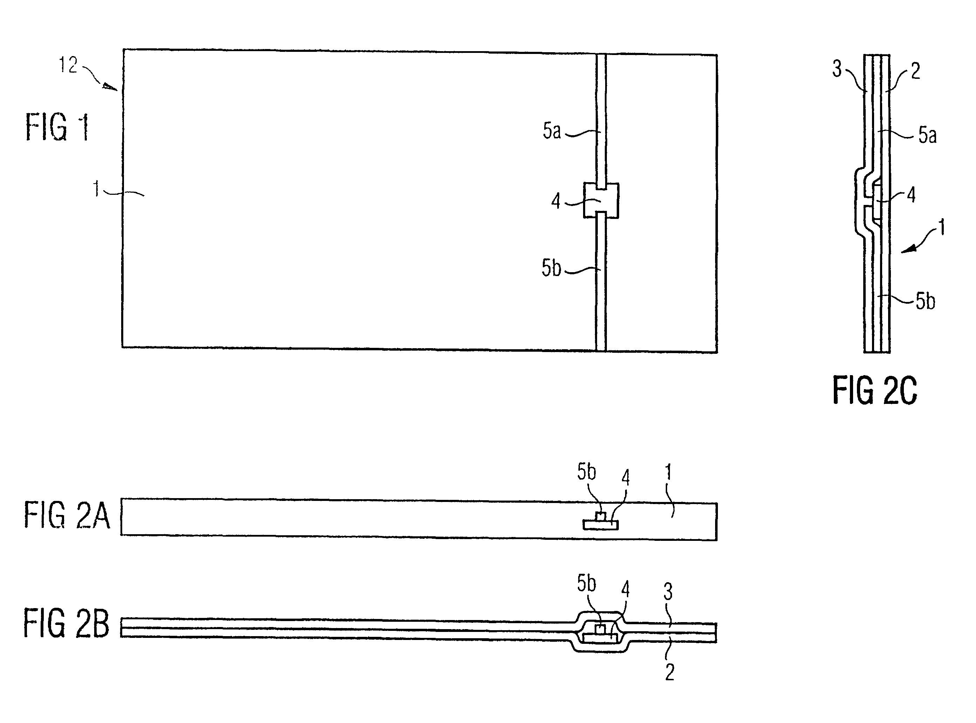

Figur 1 zeigt einen gattungsgemäßen Transponder 12 in einer Draufsicht. Der Transponder 12 weist einen Träger 1 auf, der in Form eines Rechtecks ausgebildet ist. Parallel zu einer der kurzen Seitenkanten ist die Antenne angeordnet, aus einem ersten elektrischen Leiter 5a und einem zweiten elektrischen Leiter 5b besteht. Mit jeweils einem Ende sind die elektrischen Leiter 5a, 5b mit einem Halbleiterchip 4 elektrisch und mechanisch verbunden. Die elektrischen Leiter 5a, 5b bilden einen Dipol. In dem Ausführungsbeispiel weist der Träger 1 eine rechteckige Form auf. Die Abmaße des Trägers 1 sind jedoch nicht auf diese geometrische Ausführung beschränkt. Der Träger 1 könnte ebenso rund, oval, quadratisch usw. ausgebildet sein.

Wie aus den Figuren 2a bis 2c hervorgeht, weist der Träger 1 eine flächige Form auf. Die Figuren 2a bis 2c zeigen verschiedene Ausgestaltungsmöglichkeiten, wie die elektrischen Leiter 5a, 5b zusammen mit dem Halbleiterchip 4 in dem flächigen Träger 1 angeordnet sein können.

In der Figur 2a sind die elektrischen Leiter 5a, 5b zusammen mit dem Halbleiterchip 4 in den Träger 1 eingelassen. Der Träger 1 könnte beispielsweise aus einem Kunststoff bestehen, in den die Antenne zusammen mit dem Halbleiterchip 4 eingelassen ist.

In der Figur 2b besteht der Träger 1 aus einer ersten Lage 2 und einer zweiten Lage 3, die übereinander angeordnet sind. Die elektrischen Leiter 5a, 5b sind mit dem Halbleiterchip 4 zwischen der ersten und der zweiten Lage 2, 3 angeordnet. An der Stelle der elektrischen Leiter und des Halbleiterchips weist der Träger dann eine leichte Erhöhung auf. Sind die Schichtdicken der ersten und der zweiten Lage 2, 3 gegenüber den Abmassen der elektrischen Leiter 5a, 5b und dem Halbleiterchip 4 groß, so tritt die Erhebung gegenüber den Hauptflächen des Trägers nur gering hervor.

Figur 2c zeigt den aus Figur 1 bekannten Transponder in einem Querschnitt durch die kurze Seitenkante. Wie in Figur 2b besteht der Träger 1 aus einer ersten und einer zweiten Lage 2, 3, zwischen denen der Verbund aus den elektrischen Leitern 5a, 5b und dem Halbleiterchip 4 angeordnet ist. Aus der Figur 2c wird ersichtlich, daß der erste und der zweite elektrische Leiter 5a, 5b nicht elektrisch leitend miteinander verbunden sind. Das jeweils dem Inneren des Trägers zugewandte Ende der elektrischen Leiter 5a, 5b ist jeweils mit einem elektrischen Kontakt des Halbleiterchips 4 verbunden. Die nach außen gewandten Enden der elektrischen Leiter 5a, 5b reichen in dem vorliegenden Ausführungsbeispiel bis zu den Seitenrändern des Trägers 1.

Für die elektrische Kopplung zwischen dem Transponder 12 und einem (nicht gezeigten) elektronischen Gerät ist nunmehr einmal der Abstand zwischen dem Transponder und dem elektronischen Gerät und andererseits die Fläche der Antenne, gebildet aus den elektrischen Leitern 5a, 5b, verantwortlich. Die Fläche der Antenne bestimmt sich somit aus der Breite, des elektrischen Leiters die üblicherweise durch das Herstellverfahren vorgegeben ist und der Länge, welche durch die Abmasse des Trägers 1 bestimmt ist. Eine gute kapazitive Kopplung zwischen dem Transponder 12 und dem elektronischen Gerät ist somit nur gegeben, sofern der Abstand einen bestimmten Wert nicht überschreitet.

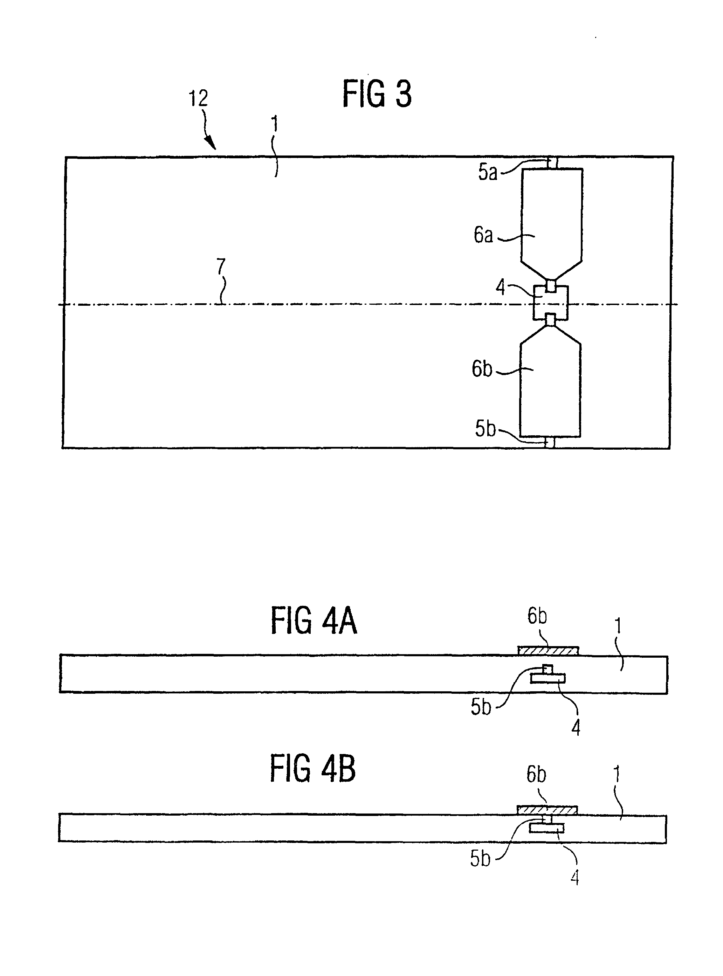

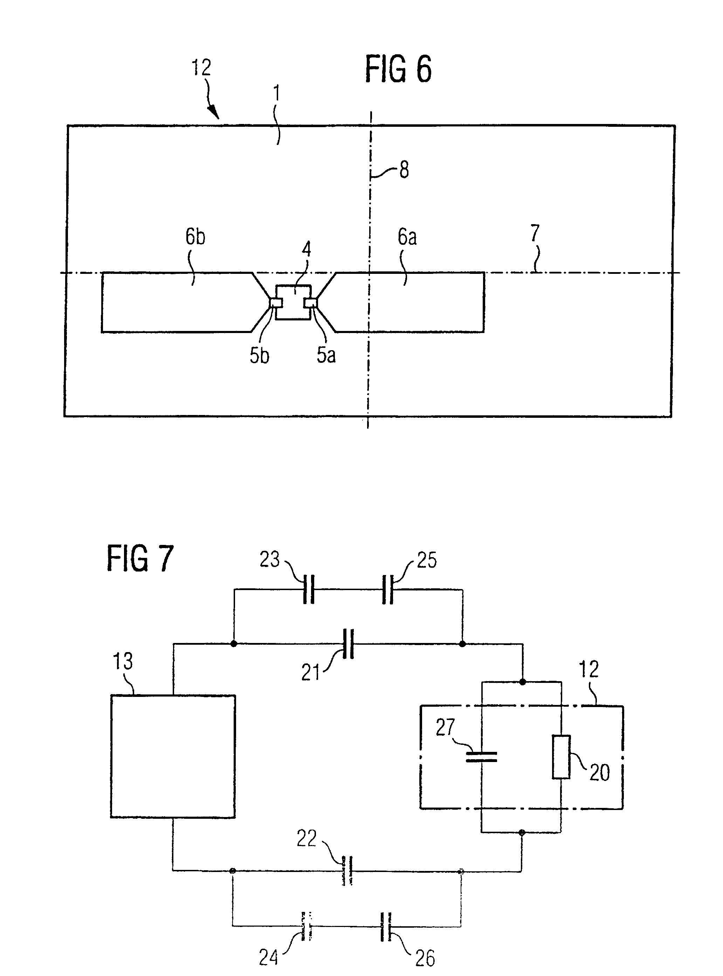

Dieser Nachteil kann durch die vorliegende Erfindung umgangen werden. Figur 3 zeigt in einer Draufsicht ein erstes Ausführungsbeispiel der Erfindung. Der Transponder 12 weist wiederum einen flächigen Träger 1 auf, der eine parallel zu den kurzen Seitenkanten des Trägers 1 ausgerichtete Antenne, bestehend aus den elektrischen Leitern 5a, 5b aufweist. Zur Erhöhung der kapazitiven Kopplung ist nunmehr auf einer ersten Hauptseite 9 eine elektrisch leitfähige Schicht 6a, 6b aufgebracht. Entsprechend der Ausgestaltung der Antenne aus den elektrischen Leitern 5a, 5b sind zwei leitfähige Schichten 6a, 6b vorgesehen, die jeweils einem elektrischen Leiter 5a, 5b zugeordnet sind. Die leitfähigen Schichten 6a, 6b sind dabei überlappend mit den elektrischen Leitern 5a, 5b angeordnet. Wie aus Figur 3 ersichtlich ist, sind die leitfähigen Schichten 6a, 6b symmetrisch um die elektrischen Leiter 5a, 5b angeordnet. In der Figur 3 sind die elektrischen Leiter 5a, 5b nicht vollständig von den leitfähigen Schichten 6a, 6b überlappt. Dies ist auch nicht notwendig, sofern die elektrisch leitfähigen Schichten 6a, 6b eine geeignet große Fläche aufweisen.
Im Gegensatz dazu zeigt die Figur 5 ein zweites Ausführungsbeispiel, in dem die leitfähigen Schichten 6a, 6b die elektrischen Leiter 5a, 5b vollständig überdecken.

Die hochohmigen Schichten können auf dem Träger 1 aufgedruckt werden. Sie werden vorteilhafter Weise farblos und durchsichtig aufgebracht, so daß sie das Erscheinungsbild des Trägers 1 nicht stören. Da der flächige Träger in der Regel auch beim Stand der Technik bedruckt wird, um z.B. ein Firmenlogo oder eine Nummer oder ein Bild aufzubringen, muß am Herstellungsverfahren nichts geändert werden, da der Druckvorgang der hochohmigen Schichten zusammen mit dem Bedrucken der Oberfläche erfolgen kann.

Die Figuren 4a bis 4d zeigen verschiedene Ausführungsbeispiele des erfindungsgemäßen flächigen Trägers jeweils in einem Querschnitt. In der Figur 4a ist der flächige Träger 1 beispielsweise aus einem Kunststoff ausgeführt, in dessen Inneren der Halbleiterchip 4 und die elektrischen Leiter 5a, 5b eingebracht sind. Die elektrisch leitfähigen Schichten 6a, 6b sind auf die erste Hauptseite 9 des flächigen Trägers 1 aufgebracht. Aus dieser Darstellung wird ersichtlich, daß die leitfähigen Schichten 6a, 6b und die elektrischen Leiter 5a, 5b miteinander überlappen. Die elektrischen Leiter 5a, 5b und die leitfähigen Schichten sind voneinander beabstandet angeordnet. Der flächige Träger 1 stellt somit ein Dieletrikum zwischen den beiden "Elektroden" der aus dem elektrischen Leiter und der leitfähigen Schicht gebildeten Kapazität dar. Da der Abstand zwischen der leitfähigen Schicht und dem elektrischen Leiter jedoch sehr gering ist, wird eine hohe Koppelkapazität erzielt.

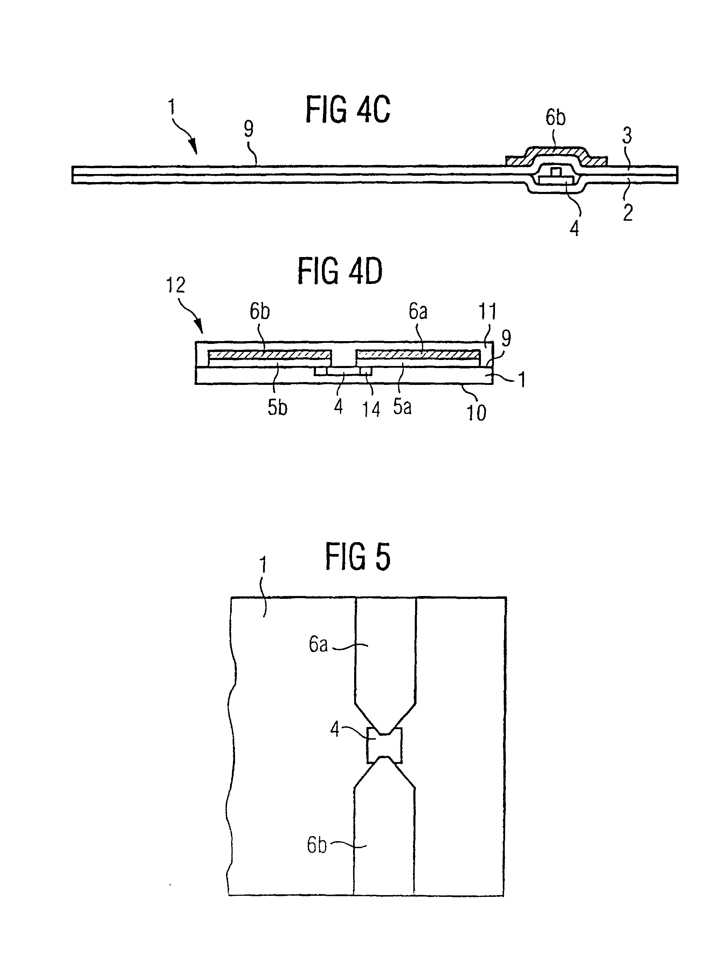

Die Koppelkapazität kann weiter verstärkt werden, indem, wie in Figur 4b gezeigt, die elektrischen Leiter 5a, 5b bis an die erste Hauptseite 9 reichen. In diesem Fall kann die elektrisch leitfähigen Schicht 6a, 6b in direkten elektrischen Kontakt mit den elektrischen Leitern 5a, 5b gebracht werden. In diesem Fall ist die Kopplung maximal. Der flächige Träger 1 kann auch, wie in Figur 4c gezeigt aus einer ersten und einer zweiten Lage 2, 3 bestehen, zwischen denen sich die Anordnung aus dem Halbleiterchip 4 und den elektrischen Leitern 5a, 5b befindet. Auf der ersten Hauptseite 9 des flächigen Trägers 1 ist dann wiederum die elektrisch leitfähige Schicht 6, 6b angeordnet.

Figur 4d zeigt ein weiteres Ausführungsbeispiel der erfindungsgemäßen Anordnung in einem Querschnitt durch die kurze Seite des Transponders 12. Der flächige Träger 1 besteht beispielsweise aus Kunststoff, auf dessen erster Hauptseite 9 eine Ausnehmung 14 vorgesehen ist. In dieser Ausnehmung 14 ist der Halbleiterchip 4 eingebracht. Die elektrischen Leiter 5a, 5b kommen auf der ersten Hauptseite 9 des Trägers 1 zum liegen. Mit diesen stehen die elektrisch leitfähigen Schichten 6a, 6b in direktem Kontakt. Die leitfähigen Schichten überlappen die elektrischen Leiter 5a, 5b dabei vollständig. Zum Schutz vor einer mechanischen Beschädigung weist der Transponder 12 eine Decklage 11 auf, die über der Anordnung aus der leitfähigen Schicht, dem elektrischen Leiter und dem Halbleiterchip 4 aufgebracht ist.

Figur 6 zeigt ein drittes Ausführungsbeispiel, das sich von den vorherigen nur dadurch unterscheidet, daß die Anordnung aus dem Halbleiterchip, den elektrischen Leitern 5a, 5b und der leitfähigen Schicht 6a, 6b derart auf dem flächigen Träger 1 angeordnet ist, daß der Halbleiterchip 4 nicht auf den Symmetrieachsen 7 bzw. 8 zum Liegen kommt. In diesem Fall ist sichergestellt, daß durch ein Knicken oder Falten des flächigen Trägers, der bevorzugt aus Papier besteht, eine Beschädigung des Halbleiters verhindert werden kann.

Anhand der Figur 7, die ein elektrisches Ersatzschaltbild der erfindungsgemäßen Anordnung aus dem Transponder 12 und einem elektronischen Gerät 13 darstellt, soll die Wirkungsweise näher verdeutlicht werden. Ein elektrisches Ersatzschaltbild des Transponders 12 besteht vereinfacht aus einer Parallelschaltung aus einer Kapazität 27 und einem Widerstand 20. Der Austausch von Daten und Energie zwischen dem Transponder 12 und dem elektronischen Gerät 13, das in dem vorliegenden Ersatzschaltbild nicht näher dargestellt ist, wird kapazitiv bewirkt. Mit 21 und 22 sind dabei Kapazitäten bezeichnet, die zwischen der Antenne des elektronischen Gerätes 13 und den elektrischen Leitern 5a, 5b, die den elektrischen Dipol des Transponders 12 bilden, bestehen. Mit 23 und 24 sind die Kapazitäten zwischen der Antenne des elektronischen Gerätes 13 und den aufgedruckten leitfähigen Schichten 6a, 6b bezeichnet. Die Bezugszeichen 25 und 26 bezeichnen die Kapazitäten zwischen den leitfähigen Schichten 6a, 6b und den elektrischen Leitern 5a, 5b des Transponders 12. Die Kapazitäten 23, 25 sind dabei parallel mit der Kapazität 21 verschalten. Entsprechend sind die Kapazitäten 24 und 26 mit der Kapazität 22 verschalten. Durch die Abschirmwirkung der aufgedruckten leitfähigen Schichten 6a, 6b werden die Kapazitäten 21, 22 zwar verkleinert. Diese Verkleinerung wird durch die zusätzlichen Kapazitäten 23, 25 bzw. 24, 26 bei weitem überkompensiert. Die Kapazitäten 23, 24, die zwischen der Antenne des elektrischen Gerätes 13 und den leitfähigen Schichten 6a, 6b bestehen, sind aufgrund der großen Fläche der leitfähigen Schicht relativ groß. Auch die Kapazitäten 25 und 26 zwischen den leitfähigen Schichten und den elektrischen Leitern sind groß, da der Abstand der leitfähigen Schicht zu den jeweiligen elektrischen Leitern 5a, 5b sehr klein ist. Im Maximalfall beträgt der Abstand die Hälfte der Dicke des Trägers 1.

Mit der Erfindung ist es somit auf einfache und kostengünstige Weise möglich, einen Transponder bereitzustellen, der gegenüber dem Stand der Technik eine wesentlich größere Koppelkapazität aufweist. Somit ist ein betreiben des Transponders auch bei größeren Entfernungen noch möglich.

## Patentansprüche

1. Flächiger Träger (1) mit mindestens einem Halbleiterchip (4), der mit einer Antenne (5a, 5b) zum Austausch von Daten und Energie mit einem elektronischen Gerät (13) verbunden ist, wobei die Antenne aus zwei elektrischen Leitern (5a, 5b) besteht,
**dadurch gekennzeichnet, daß**
eine leitfähige Schicht (6a, 6b) auf dem Träger (1) vorgesehen ist, die mit den elektrischen Leitern (5a, 5b) der Antenne überlappt.

2. Träger nach Anspruch 1,
**dadurch gekennzeichnet, daß**
jeder der zwei elektrischen Leiter (5a, 5b) mit einer zugeordneten leitfähigen Schicht (6a, 6b) überlappt.

3. Träger nach Anspruch 2,
**dadurch gekennzeichnet, daß**
die jeweilige leitfähige Schicht (6a, 6b) den jeweiligen elektrischen Leiter vollständig überdeckt.

4. Träger nach einer der Ansprüche 1 bis 3,
**dadurch gekennzeichnet, daß**
die leitfähige Schicht (6a, 6b) durch ein Dielektrikum beabstandet zu den elektrischen Leitern (5a, 5b) zum Liegen kommt.

5. Träger nach einem der Ansprüche 1 bis 4,
**dadurch gekennzeichnet, daß**
die elektrischen Leiter (5a, 5b) zusammen mit dem Halbleiterchip (4) in den Träger (1) eingebettet sind.

6. Träger nach einem der Ansprüche 1 bis 5,
**dadurch gekennzeichnet, daß**
die elektrischen Leiter (5a, 5b) auf einer ersten Hauptseite (9) des Trägers (1) aufgebracht sind.

7. Träger nach einem der Ansprüche 1 bis 3 oder 6,
**dadurch gekennzeichnet, daß**
die leitfähige Schicht (6a, 6b) in direktem elektrischen Kontakt mit den elektrischen Leitern (5a, 5b) steht.

8. Träger nach einem der Ansprüche 1 bis 7,
**dadurch gekennzeichnet, daß**
die leitfähige Schicht (6a, 6b) bezüglich der elektrischen Leiter (5a, 5b) spiegelsymmetrisch angeordnet ist.

9. Träger nach einem der Ansprüche 1 bis 8,
**dadurch gekennzeichnet, daß**
die elektrischen Leiter (5a, 5b) symmetrisch bezüglich des Halbleiterchips angeordnet sind.

10. Träger nach einem der Ansprüche 1 bis 9,
**dadurch gekennzeichnet, daß**
der Halbleiterchip (4) außerhalb der Spiegelachsen des Trägers (1) gelegen ist.

11. Träger nach einem der Ansprüche 1 bis 10,
**dadurch gekennzeichnet, daß**
der Träger (1) aus Papier besteht.

12. Träger nach einem der Ansprüche 1 bis 11,
**dadurch gekennzeichnet, daß**
die Fläche der jeweiligen leitfähigen Schicht (5a, 5b) größer als die des jeweiligen elektrischen Leiters (5a, 5b) ist.

## Claims

1. Flat mount (1) having at least one semiconductor chip (4) which is connected to an antenna (5a, 5b) for interchanging data and power with an electronic appliance (13), with the antenna comprising two electrical conductors (5a, 5b),
**characterized in that**
a conductive layer (6a, 6b) is provided on the mount (1) and overlaps the electrical conductors (5a, 5b) of the antenna.

2. Mount according to Claim 1,
**characterized in that**
each of the two electrical conductors (5a, 5b) overlaps an associated conductive layer (6a, 6b).

3. Mount according to Claim 2,
**characterized in that**
the respective conductive layer (6a, 6b) completely covers the respective electrical conductor.

4. Mount according to one of Claims 1 to 3,
**characterized in that**
the conductive layer (6a, 6b) is located at a distance from the electrical conductors (5a, 5b), separated by a dielectric.

5. Mount according to one of Claims 1 to 4,
**characterized in that**
the electrical conductors (5a, 5b) are embedded together with the semiconductor chip (4) in the mount (1).

6. Mount according to one of Claims 1 to 5,
**characterized in that**
the electrical conductors (5a, 5b) are applied on a first main face (9) of the mount (1).

7. Mount according to one of Claims 1 to 3 or 6,
**characterized in that**
the conductive layer (6a, 6b) makes direct electrical contact with the electrical conductors (5a, 5b).

8. Mount according to one of Claims 1 to 7,
**characterized in that**
the conductive layer (6a, 6b) is arranged with mirror-image symmetry with respect to the electrical conductors (5a, 5b).

9. Mount according to one of Claims 1 to 8,
**characterized in that**
the electrical conductors (5a, 5b) are arranged symmetrically with respect to the semiconductor chip.

10. Mount according to one of Claims 1 to 9,
**characterized in that**
the semiconductor chip (4) is located outside the mirror-image axes of the mount (1).

11. Mount according to one of Claims 1 to 10,
**characterized in that**
the mount (1) is composed of paper.

12. Mount according to one of Claims 1 to 11,
**characterized in that**
the surface area of the respective conductive layer (5a, 5b) is larger than that of the respective electrical conductor (5a, 5b).

## Revendications

1. Support (1) plat comportant au moins une puce (4) à semiconducteur, qui est reliée à une antenne (5a, 5b) pour échanger des données et de l'énergie avec un appareil (13) électronique, l'antenne étant constituée de deux conducteurs (5a, 5b) électriques,
**caractérisé en ce qu'**il est prévu sur le support (1) une couche (6a, 6b) conductrice qui est à recouvrement avec les conducteurs (5a, 5b) électriques de l'antenne.

2. Support suivant la revendication 1,
**caractérisé en ce que** chacun des deux conducteurs (5a, 5b) électriques est à recouvrement avec une couche (6a, 6b) conductrice associée.

3. Support suivant la revendication 2,
**caractérisé en ce que** la couche (6a, 6b) conductrice respective recouvre entièrement le conducteur électrique respectif.

4. Support suivant l'une des revendications 1 à 3,
**caractérisé en ce que** la couche (6a, 6b) conductrice vient sur les conducteurs (5a, 5b) électriques en étant maintenue à distance par un diélectrique.

5. Support suivant l'une des revendications 1 à 4,
**caractérisé en ce que** les conducteurs (5a, 5b) électriques sont incorporés ensemble avec la puce (4) à semiconducteur dans le support (1).

6. Support suivant l'une de revendications 1 à 5,
**caractérisé en ce que** les conducteurs (5a, 5b) électriques sont déposés sur une première face (9) principale du support.

7. Support suivant l'une des revendications 1 à 3 ou 6,
**caractérisé en ce que** la couche (6a, 6b) conductrice est en contact électrique direct avec les conducteurs (5a, 5b) électriques.

8. Support suivant l'une des revendications 1 à 7,
**caractérisé en ce que** la couche (6a, 6b) conductrice est disposée à symétrie comme en un miroir par rapport aux conducteurs (5a, 5b) électriques.

9. Support suivant l'une des revendications 1 à 8,
**caractérisé en ce que** les conducteurs (5a, 5b) électriques sont disposés symétriquement par rapport à la puce à semiconducteur.

10. Support suivant l'une des revendications 1 à 9,
**caractérisé en ce que** la puce (4) à semiconducteur est disposée à l'extérieur de l'axe de symétrie comme en un miroir du support (1).

11. Support suivant l'une des revendications 1 à 10,
**caractérisé en ce que** le support (1) est en papier.

12. Support suivant l'une des revendications 1 à 11,
**caractérisé en ce que** la surface de la couche (5a, 5b) conductrice respective est plus grande que celle du conducteur (5a, 5b) électrique respectif.
